# FASCICULE DE BREVET EUROPEEN

(11) **EP 2 666 204 B1**
(45) Date de publication et mention de la délivrance du brevet: **04.03.2015**
(21) Numéro de dépôt: 12706074.7
(22) Date de dépôt: 20.01.2012
(51) Int. Cl.: H01M 10/42, H01M 10/44, G01R 31/36, H01M 10/0525, H02J 7/00, H01M 6/50

(54) **PROCEDE D'EVALUATION DE L'AUTODECHARGE D'UN ACCUMULATEUR AU LITHIUM**
VERFAHREN ZUR SCHÄTZUNG DER SELBSTENTLADUNG EINER LITHIUMBATTERIE
METHOD FOR ESTIMATING THE SELF-DISCHARGE OF A LITHIUM BATTERY

(30) Priorité: 20.01.2011 FR 1100174
(43) Date de publication de la demande: 27.11.2013
(73) Titulaire: Commissariat à l'Énergie Atomique et aux Énergies Alternatives, 75015 Paris (FR)
(72) Inventeur: MARTIN, Nelly, 38210 Montaud (FR); LE CRAS, Frédéric, 33140 Villenave d'Ornon (FR)
(74) Mandataire: Talbot, Alexandre
(86) Numéro de dépôt international: PCT/FR2012/000028
(87) Numéro de publication internationale: WO 2012/098316

(56) Documents cités:
- JP-A- 2002 343 446
- JP-A- 2003 100 351
- JP-A- 2003 317 810
- US-A1- 2007 082 264

## Description

### Domaine technique de l'invention

L'invention est relative à un procédé d'évaluation de l'autodécharge d'un accumulateur au lithium par la mesure de la tension en circuit ouvert de l'accumulateur.

### État de la technique

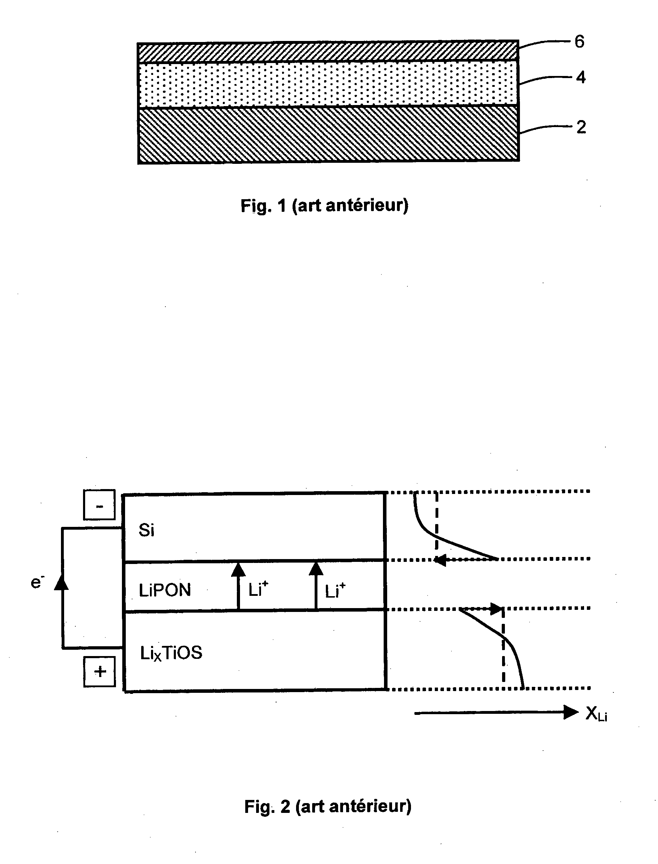

La figure 1 représente une architecture classique d'accumulateur au lithium. L'accumulateur au lithium comprend successivement une électrode positive 2, un électrolyte 4 et une électrode négative 6. Le principe de fonctionnement repose sur l'insertion-désinsertion (ou intercalation-désintercalation) d'un ion lithium Li⁺ dans l'électrode positive 2. Le matériau de l'électrode positive est alors appelé matériau d'insertion du lithium.

L'électrode positive comprend un matériau d'insertion conducteur ionique et conducteur électronique, par exemple l'oxysulfure de titane (TiOS). L'électrolyte est un isolant électrique ayant une forte conductivité ionique tel que l'oxynitrure de lithium et de phosphore (LiPON). La nature de l'électrode négative varie en fonction de la catégorie de l'accumulateur.

Dans les accumulateurs lithium-ion, l'électrode négative 6 comprend également un matériau d'insertion. Les ions Li⁺ font des allers-retours entre les électrodes 2 et 6 à chaque charge et décharge de l'accumulateur. Le matériau d'insertion de l'électrode 6 est généralement choisi parmi les oxydes de métaux de transition (LiNiO₂, SnO, l'oxyde d'indium et de plomb...) et les éléments simples (Si, Ge, C...).

La figure 2 représente, de manière schématique, le fonctionnement d'un accumulateur lithium-ion Li_{X}TiOS/LiPON/Si lors d'une charge. Des électrons circulent de l'électrode positive en LiTiOS à l'électrode négative en Si par un circuit électrique extérieur et des ions Li⁺ migrent de l'électrode positive vers l'électrode négative à travers l'électrolyte. Les demi-réactions de charge s'écrivent :

à l'électrode négative : *Si* + *Li*⁺ + *e⁻ → LiSi* (1),

à l'électrode positive : *LiTiOS → TiOS* + *Li*⁺ + *e⁻* (2).

L'appauvrissement de l'électrode positive en ions Li⁺ provoque une augmentation de son potentiel électrique. A l'inverse, l'électrode négative se chargeant en ions Li⁺, le potentiel de celle-ci diminue. Il en résulte une augmentation de la tension de l'accumulateur.

En fait, la tension d'un accumulateur correspond à la différence des potentiels aux interfaces électrode positive/électrolyte et électrolyte/électrode négative. Ces potentiels varient en fonction de la quantité d'ions Li⁺ présente aux interfaces.

En plaçant un accumulateur complètement chargé en circuit ouvert, une chute progressive de la tension aux bornes de l'accumulateur peut être observée. Cette diminution est liée, d'une part, à la relaxation de l'accumulateur, et d'autre part, à son autodécharge.

Le phénomène de relaxation comprend notamment l'équilibrage des concentrations en Li⁺ à l'intérieur des matériaux d'électrode après une charge. Ce phénomène est décrit ci-après en relation avec l'accumulateur Li_{X}TiOS/LiPON/Si de la figure 2.

Les courbes à droite de la figure 2 représentent le gradient de concentration d'ions lithium X_{Li} à l'intérieur de l'électrode positive (en bas) et à l'intérieur de l'électrode négative (en haut), avant (trait plein) et après (trait pointillés) relaxation de l'accumulateur.

Lors de la charge, les ions Li⁺ s'insèrent dans l'électrode négative en Si au niveau de l'interface avec l'électrolyte en LiPON. La quantité X_{Li} est donc initialement plus élevée au niveau de cette interface que dans le reste du silicium, comme cela est représenté par la courbe supérieure en trait plein. Après la charge, les ions Li⁺ continuent de diffuser à travers le silicium. La quantité X_{Li} tend alors à s'homogénéiser dans le matériau de l'électrode (courbe supérieure en traits pointillés).

A l'inverse, l'interface LiₓTiOS/LiPON s'appauvrit en ions Li⁺ plus rapidement que le reste de l'électrode positive pendant la charge. La courbe inférieure en trait plein montre que la quantité en ions Li⁺ est plus faible à l'interface. Les ions Li⁺ diffusent ensuite vers l'interface de manière à égaliser la quantité X_{Li} dans l'électrode positive (courbe inférieure en traits pointillés).

La chute de la tension liée à la relaxation de l'accumulateur s'explique donc par des variations de la quantité d'ions Li⁺ aux interfaces avec l'électrolyte.

L'autodécharge de l'accumulateur correspond à la mise en oeuvre de réactions électrochimiques parasites aux électrodes et/ou au transfert d'électrons d'une électrode à l'autre dû à des défauts de construction et/ou à la conductivité électronique de l'électrolyte. Cette autodécharge est notable pour les accumulateurs classiques à électrolyte aqueux. Par contre, dans les accumulateurs au lithium, l'utilisation d'un électrolyte solide limite les réactions parasites. Le courant d'électrons au travers de l'électrolyte est extrêmement faible compte tenu de la résistivité électrique élévée du LiPON. Les niveaux d'autodécharge sont bas, ce qui rend leur détermination complexe.

L'autodécharge des accumulateurs au lithium est évaluée de façon classique en mesurant la diminution de la tension en circuit ouvert V_{CO} de l'accumulateur au cours du temps. Toutefois, cette diminution est également liée à la relaxation de l'accumulateur, comme cela a été décrit précédemment. Il est donc nécessaire d'attendre une période de temps suffisamment longue de manière que l'accumulateur soit relaxé. Après ce temps de relaxation, la diminution de la tension V_{CO} correspond à l'autodécharge.

En fait, le temps de relaxation dépend des coefficients de diffusion du lithium dans les matériaux d'électrode. A température ambiante, ce coefficient est élevé pour les matériaux d'électrode positive, de l'ordre de 10⁻¹¹ à 10⁻⁹ cm²·s⁻¹, mais faible pour les matériaux d'électrode négative comme le silicium, de 10⁻¹⁵ à 10⁻¹⁴ cm².s⁻¹. Le profil de la quantité X_{Li} dans l'électrode négative évolue donc lentement, ce qui explique des temps de relaxation de plusieurs heures, voire de plusieurs centaines d'heures.

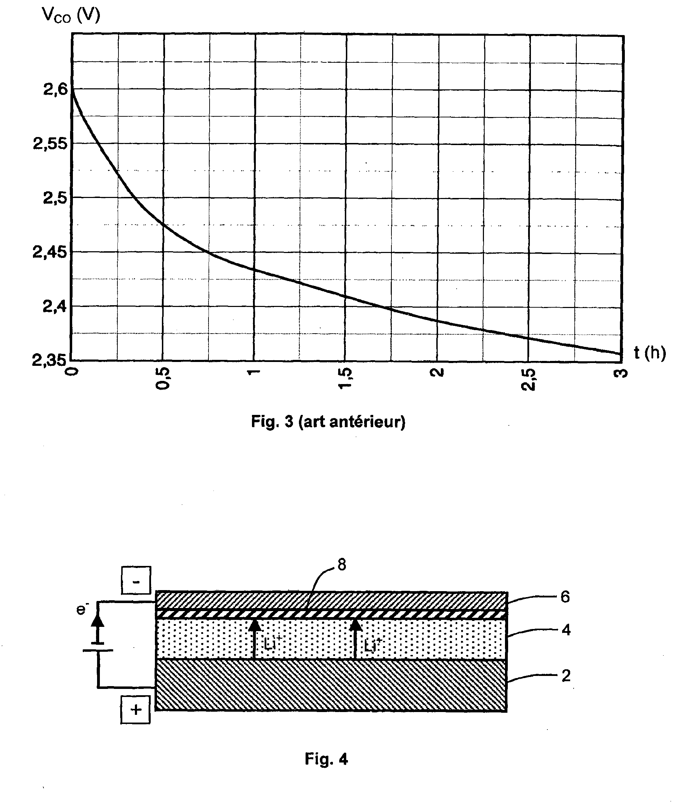

La figure 3 représente à titre d'exemple la tension en circuit ouvert V_{CO} après une charge nominale à 2,6 V de l'accumulateur de la figure 2. On constate que la pente de la courbe continue de varier 3 heures après la fin de la charge. Cela signifie que la relaxation n'est toujours pas terminée.

Ce temps d'attente rallonge considérablement la durée d'évaluation de l'autodécharge. Une telle technique est donc difficilement applicable à grande échelle, en particulier dans le cadre des contrôles de qualité des accumulateurs lithium-ion.

L'autodécharge, exprimée par une diminution de la tension par unité de temps, peut également être appelée courant de fuite de l'accumulateur.

L'autodécharge induit nécessairement une diminution de la capacité utilisable de l'accumulateur. Une autre technique d'évaluation consiste à charger l'accumulateur, à le stocker à l'état chargé pendant une durée prédéterminée et à le décharger à courant constant jusqu'à une tension seuil. L'évolution de la capacité restituée en décharge en fonction du temps permet alors de calculer la perte de capacité nominale par unité de temps, c'est-à-dire l'autodécharge. Cette technique requiert également un temps de stockage important pendant lequel se produit la relaxation de l'accumulateur.

Le document JP2002/343446 divulgue un procédé de détermination du courant d'autodécharge d'un accumulateur lithium-ion.

### Résumé de l'invention

On constate qu'il existe un besoin de prévoir un procédé simple et rapide pour déterminer le courant d'autodécharge d'un accumulateur lithium-ion muni d'une électrode positive, d'une électrode négative comprenant un matériau d'insertion d'ions lithium et d'un électrolyte disposé entre les électrodes positive et négative.

On tend à satisfaire ce besoin en chargeant l'accumulateur jusqu'à formation d'une couche de lithium métallique entre l'électrolyte et l'électrode négative, en mesurant la tension en circuit ouvert de l'accumulateur en deux instants, et en déterminant le courant d'autodécharge à partir de la variation de la tension mesurée entre les deux instants.

Selon un mode de réalisation, l'électrode positive présente une quantité de lithium supérieure à la quantité de lithium que peut insérer l'électrode négative.

Selon une variante de réalisation, les paramètres de charge sont choisis de manière à provoquer un flux d'ions lithium supérieur au flux d'ions maximal pouvant diffuser au sein de l'électrode négative.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente une architecture classique d'accumulateur au lithium ;
- la figure 2, précédemment décrite, représente schématiquement le fonctionnement en charge d'un accumulateur Li_{X}TiOS/LiPON/Si et le gradient de concentration X_{Li} d'ions lithium dans les électrodes, avant et après relaxation de l'accumulateur ;
- la figure 3, précédemment décrite, représente l'évolution de la tension en circuit ouvert V_{CO} de l'accumulateur Li_{X}TiOS/LiPON/Si au cours du temps après une charge nominale à 2,6 V ;
- la figure 4 représente la charge d'un accumulateur lithium-ion jusqu'à formation d'une électrode métallique, permettant de déterminer rapidement le courant de fuite de l'accumulateur ;
- la figure 5 représente le potentiel V₊ de l'électrode positive et le potentiel V₋ de l'électrode négative en fonction de l'état de charge SOC de l'accumulateur, lors d'une charge de test et d'un cycle de fonctionnement nominal ; et
- la figure 6 représente l'évolution de la tension en circuit ouvert V_{CO} de l'accumulateur de la figure 4 au cours du temps.

### Description d'un mode de réalisation préféré de l'invention

On propose ici d'écourter la durée d'évaluation de l'autodécharge en diminuant le temps nécessaire à la relaxation de l'accumulateur. Pour cela, on charge l'accumulateur jusqu'à formation d'une couche de lithium métallique sur l'électrode négative. Cette couche métallique, à l'interface électrode négative/électrolyte, permet de figer le potentiel de l'électrode négative. Ainsi, le temps de relaxation dépend uniquement de la diffusion du lithium dans l'électrode positive. La diffusion étant plus rapide dans l'électrode positive que dans l'électrode négative, on s'affranchit plus rapidement de la relaxation. Le courant d'autodécharge ou courant de fuite de l'accumulateur est ensuite déterminé en mesurant la tension en circuit ouvert.

On prévoit initialement un accumulateur lithium-ion muni d'une électrode positive 2, d'une électrode négative 6 et d'un électrolyte 4 disposé entre les électrodes 2 et 6, comme illustré sur la figure 1. Les électrodes 2 et 6 comprennent un matériau d'insertion des ions lithium, par exemple TiOS pour l'électrode positive 2 et Si pour l'électrode négative 6. En outre, au moins l'un de ces deux matériaux est lithié, c'est-à-dire qu'il contient du lithium. Le lithium est par exemple incorporé dans l'électrode positive lors de la fabrication de l'accumulateur (LiₓTiOS). L'électrolyte est de préférence de type solide, par exemple du LiPON.

A la figure 4, on charge l'accumulateur lithium-ion jusqu'à formation d'une couche 8 en lithium métallique entre l'électrolyte 4 et l'électrode négative 6.

Dans un mode de réalisation préférentiel, la couche métallique 8 est formée par une charge complète de l'accumulateur, l'accumulateur étant déséquilibré en termes de capacité d'insertion des ions lithium. On entend par là que l'électrode positive 2 contient initialement plus d'ions Li⁺ que peut en stocker l'électrode négative 6.

Lors de la charge, les ions Li⁺ provenant de l'électrode 2 s'insèrent dans l'électrode 6 jusqu'à la saturation de celle-ci. Puis, les ions Li⁺ de l'électrode 2, en surplus par rapport à la capacité de l'électrode 6, s'électrodéposent sur la surface de l'électrode 6, formant ainsi la couche 8.

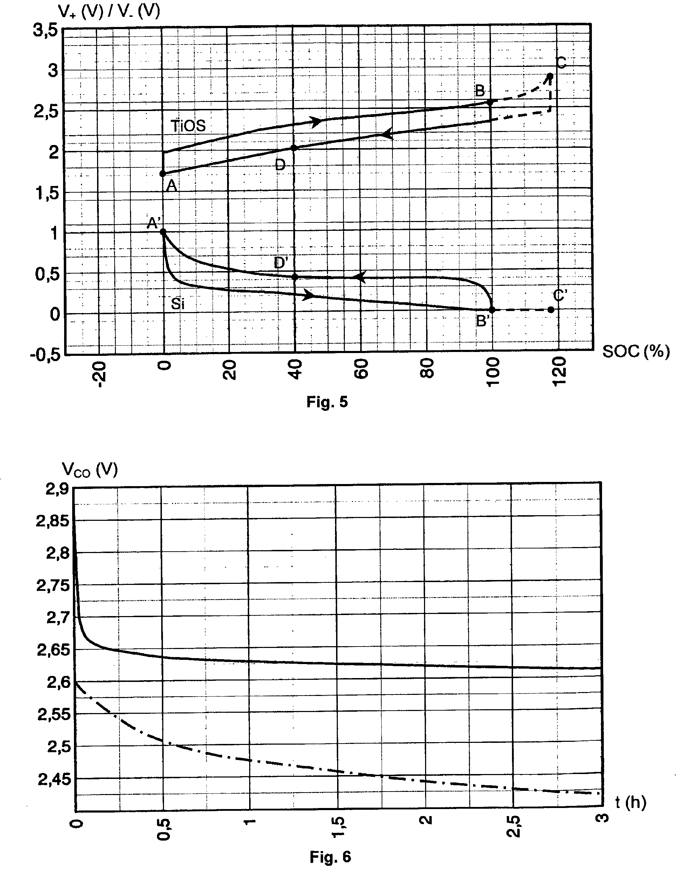

La figure 5 représente l'évolution du potentiel V₊ de l'électrode en LiₓTiOS et du potentiel V₋ de l'électrode en Si en fonction de l'état de charge SOC (« State Of Charge » en anglais) de l'accumulateur, lors d'une charge de test et lors d'un cycle de fonctionnement normal.

Les points A et A' représentent l'état initial des électrodes, par exemple juste après la fabrication de l'accumulateur. L'état de charge SOC de l'accumulateur est nul, il est donc déchargé. L'électrode en TiOS contient une quantité de lithium correspondant à un potentiel V₊ de 1,7 V par rapport au potentiel de référence Li⁺/Li. A l'inverse, l'électrode en Si est dépourvue de lithium, son potentiel est maximal (V₋ = 1 V par rapport au potentiel de référence Li⁺/Li).

Lors de la charge, le potentiel V₊ augmente compte tenu que l'électrode en LiₓTiOS libère des ions Li⁺. A l'inverse, le potentiel V₋ diminue car l'électrode en Si se charge en ions Li⁺.

En B et B', l'accumulateur est complètement chargé (SOC=100 %). Le potentiel V₊ vaut 2,6 V (vs. Li⁺/Li) et le potentiel V₋ atteint 0 V (vs. Li⁺/Li), ce qui signifie que l'électrode négative est saturée en lithium. Les portions AB et A'B' correspondent en fait à une charge nominale de l'accumulateur, c'est-à-dire une charge en fonctionnement normal.

La charge se poursuit au-delà des points B et B', par exemple en C et C' comme cela est représenté en traits pointillés sur la figure 5. Ainsi, d'autres ions Li⁺ sont extraits de l'électrode 2. Toutefois, ils ne peuvent s'insérer dans l'électrode 6 car celle-ci est saturée. Ils sont donc électrodéposés à la surface du silicium et forment la couche métallique 8. Le potentiel V₋ se maintient à 0V (vs. Li⁺/Li) tandis que le potentiel V₊ continue d'augmenter pour atteindre 2,9 V (vs. Li⁺/Li). La couche 8 constitue alors un potentiel de référence. Dans notre exemple, ce potentiel vaut 0 V (vs. Li⁺/Li).

L'accumulateur est ensuite placé en circuit ouvert et le potentiel V_{CO} aux bornes de l'accumulateur est mesuré. Le potentiel V_{CO} correspond ici au potentiel V₊ de l'électrode positive puisque le potentiel V₋ de l'électrode négative est nul. Lorsque la pente de la courbe V_{CO} (t) devient constante, on considère que l'équilibre de l'électrode positive est atteint. La pente, correspondant à une diminution de tension par unité de temps, rend compte alors du courant de fuite de l'accumulateur. On mesure la tension V_{CO} en deux instants puis on calcule le courant d'autodécharge à partir de la variation de tension entre ces deux instants. On peut également exprimer l'autodécharge en termes de capacité, en utilisant des abaques de la tension V_{CO} en fonction de l'état de charge SOC.

Après avoir déterminé l'autodécharge, l'accumulateur peut être utilisé normalement, selon des cycles de charge et décharge nominales. On fixe généralement une plage de fonctionnement, définie par une tension de coupure basse DD' (en décharge) et une tension de coupure haute BB'(en charge). L'hystérésis observée sur les courbes de la figure 5 (sauts de tension en A et B) est dû aux résistances internes et aux surtensions des réactions.

La tension de coupure haute correspond, de préférence, au seuil de saturation de l'électrode négative (ou limite d'insertion du lithium dans l'électrode négative), aux points B et B' sur la figure 5. La tension de coupure haute vaut, par exemple, V_{BAT} = V₊ (B) - V₋ (B') = 2,6 V.

La tension de coupure basse de l'accumulateur varie en fonction des matériaux d'électrode et du dispositif qu'il alimente. En général, la tension de coupure basse correspond à une décharge partielle de l'accumulateur. Cela signifie qu'une partie des ions Li⁺ est immobilisée dans l'électrode en silicium. Elle se situe par exemple aux points D et D' de la figure 5 et vaut V_{BAT}= V₊ (D) - V₋CD') = 1,7 V. Cela correspond à un pourcentage d'ions Li⁺ immobilisé de l'ordre de 23 %.

La figure 6 représente en trait plein la tension en circuit ouvert V_{CO} de l'accumulateur de la figure 4, en fonction du temps écoulé après une charge à 2,9 V. La courbe de la figure 3 a été reproduite sur le graphe en traits pointillés, à titre de comparaison.

On remarque que la stabilisation de la tension se produit bien plus rapidement dans le cas de l'accumulateur muni de la couche métallique. En effet, la pente de la courbe devient constante après une heure d'attente seulement, alors qu'au moins trois heures sont nécessaires dans le cas d'une charge nominale à 2,6 V. La durée d'évaluation de l'autodécharge est donc considérablement réduite par rapport aux techniques classiques.

Le procédé de détermination du courant d'autodécharge décrit ci-dessus est, de préférence, réalisé dans le cadre de contrôles de qualité effectués immédiatement après la fabrication de l'accumulateur. En effet, le courant d'autodécharge est une donnée importante pour juger la fiabilité d'un accumulateur. La première charge de l'accumulateur sert donc à former la couche de lithium métallique pour déterminer rapidement son courant de fuite, puis l'accumulateur est utilisé normalement.

Dans une variante de réalisation, on choisit les paramètres de charge de manière qu'une quantité importante d'ions Li⁺ soit transférée à l'électrode 6 pendant une courte période de temps. Le flux d'ions Li⁺, de l'électrode positive vers l'électrode négative, est alors supérieur au flux maximal d'ions Li⁺ pouvant diffuser au sein de l'électrode négative. L'électrode 6 ne pouvant insérer une telle quantité en si peu de temps, il se forme une couche de lithium métallique à sa surface. Le potentiel V- atteint 0 V (vs. Li⁺/Li) sans que l'accumulateur soit totalement chargé (SOC < 100 %). Dans ce cas, l'accumulateur peut être équilibré en termes de capacité d'insertion.

En d'autres termes, on charge l'accumulateur à un régime soutenu de manière à saturer l'électrode négative uniquement en surface, en quantité suffisante pour persister pendant le temps de relaxation de l'électrode positive. L'accumulateur est, de préférence, chargé à haut potentiel constant, par exemple à 2,9 V pendant trente minutes.

Le procédé de détermination du courant d'autodécharge est particulièrement intéressant pour les accumulateurs ayant une électrode négative dont le coefficient de diffusion chimique du lithium est inférieur à 10⁻⁹ cm²/s.

De nombreuses variantes et modifications du procédé de détermination du courant d'autodécharge apparaîtront à l'homme du métier. Le procédé a été décrit en relation avec un accumulateur LiTiOS/LiPON/Si. Toutefois, d'autres matériaux d'insertion pourront être utilisés, notamment LiCo₂, LiMn₂O₄, LiNi_{0,5}Mn_{1,5}O₄ pour l'électrode positive et Si, Al, Ge, SnO, LiNiO₂, l'oxyde d'indium et de plomb pour l'électrode négative. Les valeurs de tension pourront d'ailleurs varier selon la nature des matériaux d'électrode et l'application visée.

## Revendications

1. Procédé de détermination du courant d'autodécharge d'un accumulateur lithium-ion muni d'une électrode positive (2), d'une électrode négative (6) comprenant un matériau d'insertion d'ions lithium, et d'un électrolyte (4) disposé entre les électrodes positive et négative,
**caractérisé en ce qu'**il comprend les étapes suivantes :
- charger l'accumulateur jusqu'à formation d'une couche de lithium métallique (8) entre l'électrolyte (4) et l'électrode négative (6),
- mesurer la tension en circuit ouvert (V_{CO}) de l'accumulateur en deux instants, et
- déterminer le courant d'autodécharge à partir de la variation de la tension mesurée entre les deux instants.

2. Procédé selon la revendication 1, dans lequel l'électrode positive (2) présente une quantité de lithium supérieure à la quantité de lithium que peut insérer l'électrode négative (6).

3. Procédé selon l'une des revendications 1 et 2, dans lequel les paramètres de charge sont choisis de manière à provoquer un flux d'ions lithium supérieur au flux maximal d'ions lithium pouvant diffuser au sein de l'électrode négative (6).

4. Procédé selon l'une quelconque des revendications 1 à 3, dans lequel l'électrode négative (6) comprend un matériau dont le coefficient de diffusion chimique du lithium est inférieur à 10⁻⁹cm²/s.

## Patentansprüche

1. Verwahren zur Bestimmung des Selbstentladungsstroms eines Lithium-Ionen-Akkumulators, der mit einer positiven Elektrode (2), mit einer negativen Elektrode (6), umfassend ein Lithiumioneneinlagerungsmaterial, und mit einem zwischen der positiven und der negativen Elektrode angeordneten Elektrolyten (4) ausgestattet ist,
**dadurch gekennzeichnet, dass** es die folgenden Schritte umfasst:
- Laden des Akkumulators bis zur Bildung einer metallischen Lithiumschicht (8) zwischen dem Elektrolyten (4) und der negativen Elektrode (6),
- Messen der Spannung im offenen Stromkreis (Vco) des Akkumulators zu zwei Zeitpunkten und
- Bestimmen des Selbstentladungsstroms anhand der Änderung der zwischen den beiden Zeitpunkten gemessenen Spannung.

2. Verwahren nach Anspruch 1, wobei die positive Elektrode (2) eine Lithiummenge aufweist, die größer ist als die Lithiummenge, welche die negative Elektrode (6) einlagern kann.

3. Verwahren nach einem der Ansprüche 1 und 2, wobei die Ladeparameter derart gewählt sind, dass ein Lithium-Ionen-Fluss bewirkt wird, der größer ist als der maximale Lithium-Ionen-Fluss, der in die negative Elektrode (6) diffundieren kann.

4. Verfahren nach einem der Ansprüche 1 bis 3, wobei die negative Elektrode (6) ein Material umfasst, dessen chemischer Diffusionskoeffizient des Lithiums kleiner als 10⁻⁹ cm²/s ist.

## Claims

1. Method for determining the self-discharge current of a lithium-ion battery provided with a positive electrode (2), a negative electrode (6) comprising a lithium ion insertion material, and an electrolyte (4) arranged between the positive and negative electrodes,
**characterized in that** it comprises the steps of:
- charging the battery until a metal lithium layer (8) is formed between the electrolyte (4) and the negative electrode (6),
- measuring the open-circuit voltage (V_{CO}) of the battery at two moments, and
- determining the self-discharge current from the variation of the measured voltage between the two moments.

2. Method according to claim 1, wherein the positive electrode (2) comprises a quantity of lithium greater than the quantity of lithium that the negative electrode (6) is capable of inserting.

3. Method according to any of claims 1 and 2, wherein the charge parameters are selected to cause a flow of lithium ions greater than the maximum flow of lithium ions capable of diffusing within the negative electrode (6).

4. Method according to any of claims 1 to 3, wherein the negative electrode (6) comprises a material having a lithium chemical diffusion coefficient smaller than 10⁻⁹ cm²/s.
